# DEMANDE DE BREVET EUROPEEN

(11) **EP 4 790 372 A1**
(43) Date de publication de la demande: **12.08.2026**
(21) Numéro de dépôt: 26155326.7
(22) Date de dépôt: 30.01.2026
(51) Int. Cl.: G01J 5/20

(54) **DÉTECTEUR THERMIQUE D'UN RAYONNEMENT ÉLECTROMAGNÉTIQUE COMPORTANT UNE DIODE THERMOMÈTRE**

(30) Priorité: 06.02.2025 FR 2501203
(71) Demandeur: Commissariat à l'Energie Atomique et aux Energies Alternatives, 75015 Paris (FR)
(72) Inventeur: LATARGEZ, Charlotte, 38054 GRENOBLE CEDEX 09 (FR); LE COCQ, Mélanie, 38054 GRENOBLE CEDEX 09 (FR); ALIANE, Abdelkader, 38054 GRENOBLE CEDEX 09 (FR); GOUDON, Valérie, 38054 GRENOBLE CEDEX 09 (FR)
(74) Mandataire: Santarelli

(57) **Abrégé**

L'invention porte sur un détecteur thermique comportant un transducteur thermique qui comprend une diode couplée thermiquement à un absorbeur. La diode comporte une région défectueuse, une couche intercalaire et une couche de charge. La couche de charge a une concentration en porteurs majoritaires au moins 100 fois supérieure à une celle de la couche intercalaire. La région défectueuse et la couche intercalaire sont en contact avec la couche de charge de part et d'autre de celle-ci. La région défectueuse comporte des défauts cristallins et a une énergie de gap strictement inférieure à celle de la couche de charge. La couche de charge et la région défectueuse sont situées d'un même côté de la jonction. Un circuit de lecture est configuré pour polariser en inverse la diode, de sorte à étendre la zone de charges d'espace jusqu'à atteindre la région défectueuse, et lire un courant d'obscurité de la diode.

## Description

### DOMAINE TECHNIQUE

Le domaine de l'invention est celui des détecteurs thermiques d'un rayonnement électromagnétique, par exemple infrarouge ou térahertz, comportant un transducteur thermique formé d'une diode.

### ÉTAT DE LA TECHNIQUE ANTÉRIEURE

Les détecteurs thermiques d'un rayonnement électromagnétique, par exemple infrarouge ou térahertz, peuvent comporter une micro-planche suspendue au-dessus d'un substrat de lecture et thermiquement isolée de ce dernier. Agencés au moins en partie sur la micro-planche, le détecteur thermique comporte un absorbeur du rayonnement électromagnétique à détecter, et un transducteur thermique, couplé thermiquement à ce dernier. Le transducteur thermique a une propriété électrique qui varie en fonction de son échauffement. Un tel transducteur thermique peut comprendre une thermistance (par exemple, à base d'oxyde de vanadium ou de silicium amorphe), une diode (jonction p-n ou p-i-n), ou un transistor à effet de champ de type métal-oxyde-semiconducteur (ou MOSFET, selon un acronyme anglais).

Un paramètre important, caractéristique de la sensibilité d'un détecteur thermique, est la puissance équivalente de bruit (ou NEP, pour « Noise Equivalent Power », en anglais). La NEP correspond à la limite de détection du détecteur thermique. Il convient de la diminuer. Pour cela, il est possible d'accroitre l'isolation thermique de la micro-planche. Par exemple, lorsqu'elle est suspendue au-dessus du substrat de lecture par des bras d'isolation thermique, la NEP est d'autant plus faible que les bras sont plus longs et/ou fins. Il est également possible d'augmenter l'absorption du rayonnement électromagnétique par l'absorbeur, ou la sensibilité du transducteur thermique.

Lorsque le transducteur thermique met en œuvre une thermistance, sa sensibilité est caractérisée par le Coefficient Thermique de Résistance (ou TCR, pour « Temperature Coefficient of Resistance », en anglais). Il s'agit de la variation relative de sa résistance électrique en fonction d'une variation de sa température. Pour une thermistance à base d'oxyde de vanadium, le TCR peut typiquement atteindre 2 à 3 %/K en valeur absolue. Néanmoins, ce type de matériau est difficile à intégrer.

Des sensibilités comparables, voire légèrement supérieures, peuvent être atteintes avec un MOSFET ou une diode utilisés comme transducteur thermique. Dans ce cas de figure, la sensibilité est caractérisée par le Coefficient de Température en Courant (ou TCC, pour « Temperature Coefficient of Current », en anglais). Il s'agit de la variation relative du courant électrique traversant le transistor ou la diode en fonction d'une variation de sa température. Un TCC de 5 à 8 %/K peut être atteint avec une diode de type jonction p-n polarisée en direct, dépendant de certaines conditions de fonctionnement. Cependant ces types de transducteurs thermiques souffrent généralement d'un fort bruit en 1/f.

### EXPOSÉ DE L'INVENTION

L'invention a pour objectif de remédier au moins en partie aux inconvénients de l'art antérieur, et plus particulièrement de proposer un détecteur thermique d'un rayonnement électromagnétique de sensibilité améliorée et présentant un faible bruit de mesure, notamment un faible bruit en 1/f.

Pour cela, l'objet de l'invention est un détecteur thermique d'un rayonnement électromagnétique, comportant : un absorbeur configuré pour s'échauffer par absorption du rayonnement électromagnétique ; un transducteur thermique comprenant une diode couplée thermiquement à l'absorbeur, la diode comportant une région défectueuse, une couche intercalaire et une couche de charge, toutes trois intercalées entre une anode et une cathode de la diode, telles que : la couche de charge a une concentration en porteurs majoritaires au moins 100 fois supérieure à une concentration en porteurs majoritaires de la couche intercalaire, la région défectueuse et la couche intercalaire sont en contact avec la couche de charge de part et d'autre de celle-ci, la région défectueuse comporte des défauts cristallins et a une énergie de gap strictement inférieure à une énergie de gap de la couche de charge, la couche de charge et la région défectueuse sont situées d'un même côté de la diode, par rapport à une jonction de la diode.

Le détecteur thermique comporte en outre un circuit de lecture configuré pour polariser en inverse la diode à une tension de polarisation Vd strictement inférieure à sa tension de claquage en valeur absolue, de sorte à étendre une zone de charges d'espace de la diode jusqu'à atteindre la région défectueuse, et lire un courant d'obscurité de la diode lorsqu'elle est polarisée à la tension de polarisation V_{D}.

Certains aspects préférés mais non limitatifs de ce détecteur thermique sont les suivants.

La région défectueuse peut être non intentionnellement dopée.

La diode peut comporter une couche petit gap non intentionnellement dopée en contact avec la couche de charge, la région défectueuse et l'anode pouvant être deux régions disjointes de la couche petit gap. La région défectueuse peut comporter des dislocations.

La diode peut comporter une interface structurée pouvant séparer la couche de charge de la couche petit gap, de sorte à confiner les dislocations.

La région défectueuse peut comporter un nombre de dislocations par cm2 compris entre 10⁵ et 10¹².

La différence entre une énergie de gap de la couche de charge et une énergie de gap de la région défectueuse peut être supérieure à 0,38 eV.

La couche intercalaire et la couche de charge peuvent être en silicium. La couche petit gap peut être en germanium ou en un alliage de silicium et de germanium.

La concentration en porteurs majoritaires de la couche de charge et son agencement peuvent être tels qu'aucune ionisation par impact intervient dans la couche petit gap et dans la couche intercalaire lorsque la diode est polarisée à la tension de polarisation Vd.

Le circuit de lecture peut être agencé dans et/ou sur un substrat de lecture du détecteur thermique, le détecteur thermique pouvant être tel qu'il comporte une micro-planche suspendue au-dessus du substrat de lecture, sur laquelle peuvent être fixés la diode et l'absorbeur de part et d'autre de celle-ci, la diode pouvant être connectée électriquement au circuit de lecture par une portion de l'absorbeur.

Le détecteur thermique peut comporter un réflecteur formant avec l'absorbeur une cavité optique quart d'onde pour le rayonnement électromagnétique à l'intérieur de laquelle la diode peut être agencée, la diode pouvant être telle que l'énergie de gap de la région défectueuse est strictement supérieure à l'énergie du photon le plus énergétique du rayonnement électromagnétique.

L'invention porte également sur un capteur d'image thermique à obturateur global comportant une matrice de détecteurs thermiques selon l'une quelconque des caractéristiques précédentes. Le circuit de lecture de chaque détecteur thermique peut être une partie d'un circuit de lecture commun du capteur d'image, le cas échéant le circuit de lecture commun peut être configuré pour lire un courant d'obscurité de chaque diode compris entre 0,1 nA et 10 nA.

L'invention porte également sur un procédé de fabrication d'un détecteur thermique selon l'une quelconque des caractéristiques précédentes, comportant une étape de formation de la région défectueuse mettant en œuvre une hétéroépitaxie d'une première couche sur une deuxième couche, respectivement en un premier matériau et en un deuxième matériau semiconducteurs, ayant des paramètres de maille différents de sorte à créer des dislocations dans une sous-couche de la première couche destinée à accueillir la région défectueuse.

Le procédé de fabrication peut comprendre une étape d'homoépitaxie de la deuxième couche sur une couche de croissance comportant un dopage in-situ d'une sous-couche de la deuxième couche destinée à accueillir la couche de charge.

La couche de croissance peut être destinée à accueillir la cathode ou l'anode. Le procédé de fabrication peut comprendre une étape de dopage de la couche de croissance préalablement à l'étape d'homoépitaxie.

Le procédé de fabrication peut comprendre une étape de structuration de la deuxième couche préalablement à l'hétéroépitaxie.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique en coupe d'un premier exemple d'une diode essentielle à la mise en œuvre d'un détecteur thermique selon l'invention ;
la figure 1B est une vue schématique en coupe d'un deuxième exemple d'une diode essentielle à la mise en œuvre d'un détecteur thermique selon l'invention ;
la figure 2 est une vue schématique en coupe d'un détecteur thermique selon l'invention intégrant une diode selon le premier exemple ou le deuxième exemple ;
la figure 3A est un graphique donnant des résultats de mesure de TCC obtenus avec une diode selon le premier exemple, en fonction de la tension de polarisation Vd appliquée à ses bornes ;
la figure 3B est un graphique donnant les résultats de mesure de TCC de la figure 3A, en fonction du courant d'obscurité traversant la diode ;
la figure 3C est un graphique donnant des résultats de mesure de la densité spectrale de puissance du bruit à 10 Hz obtenue avec la diode de la figure 3A, en fonction du courant d'obscurité la traversant ;
la figure 4A est un graphique donnant des résultats de simulation de TCC obtenus avec des diodes en différents matériaux, en fonction de la tension de polarisation Vd appliquée à leurs bornes ;
la figure 4B est un graphique donnant les résultats de simulation de TCC de la figure 4A, en fonction du courant d'obscurité traversant les diodes ;
les figures 5A à 5D sont des vues schématiques en coupe d'étapes d'un procédé de fabrication d'une première partie d'un détecteur thermique selon l'invention, comprenant un circuit de lecture ;
les figures 6A à 6K sont des vues schématiques en coupe d'étapes d'un procédé de fabrication d'une deuxième partie du détecteur thermique selon l'invention, comprenant une diode selon le premier ou le deuxième exemple ;
les figures 7A à 7J sont des vues schématiques en coupe d'étapes finales d'un procédé de fabrication du détecteur thermique selon l'invention.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un détecteur thermique d'un rayonnement électromagnétique, par exemple infrarouge ou térahertz. Il peut s'agir d'un rayonnement électromagnétique dans le spectre infrarouge lointain (ou LWIR, pour « Long Wave Infra Red », en anglais), par exemple compris entre 8 µm et 14 µm. Le détecteur thermique est préférentiellement destiné à fonctionner à température ambiante.

Le détecteur thermique comporte un circuit de lecture, un absorbeur et un transducteur thermique. Le transducteur thermique comprend une diode polarisée en inverse par le circuit de lecture. La diode est couplée thermiquement à l'absorbeur, par exemple par conduction thermique. L'absorbeur est configuré pour s'échauffer par absorption du rayonnement électromagnétique. La diode présente une architecture particulière qui favorise l'apparition d'un courant électrique d'obscurité I_{dark} de type génération-recombinaison dominé par un courant de recombinaison Shockley-Read-Hall, connu sous l'acronyme SRH. Le circuit de lecture lit le courant d'obscurité qui est une fonction croissante de la température de la diode, et par conséquent de l'intensité du rayonnement électromagnétique à détecter.

L'architecture de la diode se compose notamment d'une couche de charge, d'une région défectueuse et d'une couche intercalaire. La région défectueuse et la couche intercalaire sont en contact avec la couche de charge, de part et d'autre de celle-ci. Des conditions de dopage de la couche de charge et de la couche intercalaire permettent de positionner, en fonctionnement, la région défectueuse dans la zone de charge d'espace, et d'augmenter ainsi un champ électrique interne à la diode à son niveau, sans générer un phénomène d'ionisation par impacts. La région défectueuse comporte des défauts cristallins. Ces derniers sont des centres de génération de charges électriques qui sont collectées aux bornes de la diode sous l'effet du champ électrique interne, générant ainsi un courant d'obscurité SRH fortement dépendant de la température de la diode. La lecture de ce courant d'obscurité permet donc d'obtenir une grande sensibilité du transducteur thermique et, par conséquent de diminuer la NEP du détecteur thermique.

En première approximation, le courant SRH assisté par des pièges dans un matériau semiconducteur d'énergie de gap E_{g} est proportionnel à ${T}^{\frac{3}{2}} {e}^{\frac{- {E}_{a}}{{k}_{B} T}}$*,* où Ea est l'énergie d'activation qui est approximativement égale à Eg/2, T est la température en Kelvin et k_{B} est la constante de Boltzmann. Ainsi, la valeur du courant SRH et sa variation relative en fonction d'une variation de la température dépendent de l'énergie de gap.

Dans le cadre de l'invention, l'énergie de gap de la région défectueuse est strictement inférieure à celle de la couche de charge. Ainsi, le courant d'obscurité est suffisamment élevé pour être lu par le circuit de lecture, notamment avec un faible rapport signal sur bruit - d'autant plus élevé que l'énergie de gap de la région défectueuse est faible - sans compromission sur la valeur du TCC - d'autant plus important que l'énergie de gap de la couche de charge est élevée. Le transducteur thermique a par conséquent une sensibilité augmentée par rapport à des transducteurs thermiques selon l'art antérieur.

Il en découle que la région défectueuse et la couche de charge sont en des matériaux semiconducteurs différents. Dans un mode de réalisation avantageux de l'invention, cette différence est exploitée pour obtenir les défauts de la région défectueuse par une croissance épitaxie générant des dislocations.

Dans la description, deux éléments sont "couplés thermiquement" lorsqu'un chemin de conduction thermique lie les deux éléments de sorte que la chaleur puisse être transférée efficacement de l'un à l'autre. Les deux éléments peuvent être en contact physique l'un avec l'autre. Ils peuvent alternativement ou en complément, être séparés l'un de l'autre par un milieu de faible résistance thermique, par exemple inférieure ou égale à 1E3 K/W. Par équivalence ou en complément, la chaleur peut être transférée de l'un à l'autre par convection et/ou rayonnement.

Des modes de réalisation particuliers vont être décrits se rapportant à un détecteur thermique comportant un absorbeur et un transducteur thermique, destiné à la détection d'un rayonnement électromagnétique infrarouge, par exemple dans l'infrarouge lointain. Cependant, ces modes de réalisation peuvent être adaptés à d'autres détecteurs thermiques, par exemple à un détecteur thermique sensible dans la gamme térahertz. Le cas échéant, l'absorbeur peut comporter une antenne connectée ou couplée électriquement à une charge résistive adaptée en impédance, la charge résistive étant couplée thermiquement avec le transducteur thermique. D'autres adaptations peuvent être nécessaires, comme par exemple l'apport d'un ou plusieurs matériaux transparents pour ajuster la hauteur d'une cavité quart d'onde entre l'absorbeur et le substrat de lecture.

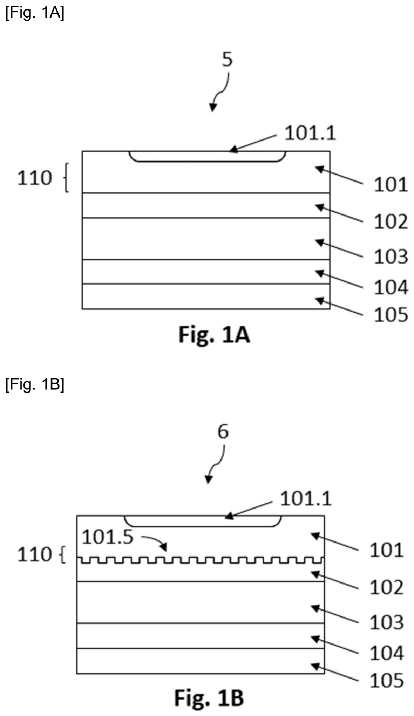

Les figures 1A et 1B sont des vues en coupe respectives d'un premier et d'un deuxième exemple de diode 5, 6 appartenant au transducteur thermique 1. Ces exemples vont être décrits relativement à une combinaison particulière de conductivités associées aux zones ou couches dopées, étant entendu que la combinaison peut être inversée sans sortir du cadre de l'invention. Ainsi, pour chaque exemple, toutes les zones dopées P peuvent être dopées N et toutes les zones dopées N peuvent être dopées P, à condition de changer le type de conductivité de toutes les zones dopées.

En figure 1A, la diode 5 comporte dans des plans successifs, distincts et parallèles, une couche petit gap 101, une couche de charge 102, une couche intercalaire 103, une couche de transition 104 et une cathode 105. Ici, chacune de ces couches ont deux faces opposées, planes et parallèles à un plan principal de la diode 5. La couche de charge 102 est en contact physique avec la couche petit gap 101 et la couche intercalaire 103. La couche de transition 104 est optionnelle. Elle est en contact avec la couche intercalaire 103 et la cathode 105 lorsqu'elle est présente, sinon la cathode 105 est directement en contact avec la couche intercalaire 103.

Par couche, on entend ici et pour la suite de la description, une étendue constituée d'une ou plusieurs sous-couches d'un matériau dont l'épaisseur suivant un axe z est inférieure, par exemple dix fois, voire vingt fois, à ses dimensions longitudinales de largeur et de longueur dans un plan (x, y) perpendiculaire à l'axe z. Une couche peut être structurée sur une de ses faces. Lorsqu'elle consiste en plusieurs sous-couches, les sous-couches peuvent être en des matériaux différents. La ou les sous-couches s'étendent dans des plans sensiblement parallèles au plan (x, y). Lorsqu'une couche possède une propriété, il est entendu que lorsqu'elle consiste en plusieurs sous-couches, toutes les sous-couches possèdent la même propriété, sauf mention explicite du contraire. A titre d'exemple, à défaut de plus de précision, une couche en métal ou en un matériau semiconducteur ou amorphe peut comporter plusieurs sous-couches, toutes respectivement en métal, en un matériau semiconducteur, ou amorphes. Une couche peut être conforme, ce qui implique qu'elle s'étend sur une surface, par exemple non-plane, et qu'elle épouse cette surface.

Sur la figure 1A, les couches 101 à 104 et la cathode 105 sont représentées avec des flancs sensiblement alignés, sans que cela soit nécessaire. A titre d'exemple, la cathode 105 peut s'étendre parallèlement au plan principal au-delà des autres couches, par exemple pour y faire reposer un contact électrique servant à la polarisation de la diode 5.

La diode 5 comporte une hétérojonction, c'est-à-dire une jonction p-n ou p-i-n séparant deux régions semiconductrices de conductivités électriques opposées et d'énergies de gap différentes. Ici, la cathode 105 et la couche de transition 104 sont dopées de type N. La couche de charge 102 est dopée P. La couche intercalaire 103 est de préférence non intentionnellement dopée ou faiblement dopée P. Elle a une concentration en porteurs majoritaires 100 fois inférieure à une concentration en porteurs majoritaires de la couche de charge 102, préférentiellement 200 fois inférieure.

La couche petit gap 101 comporte une région défectueuse 110. La région défectueuse 110 comporte des défauts agissant comme des centres de génération-recombinaison de porteurs de charge. Elle s'étend parallèlement au plan principal, en contact physique avec la couche de charge 102. Elle est en un premier matériau semiconducteur essentiellement cristallin. Les défauts peuvent être de plusieurs types comme par exemple des atomes interstitiels, des impuretés, des joints de grain... Il s'agit avantageusement de dislocations, par exemple résultant d'une épitaxie de la région défectueuse 110 sur la couche de charge 102, comme cela est le cas dans les premier et deuxième exemples de diode 5, 6.

La densité de défauts de la région défectueuse 110 peut être augmentée pour accroître le courant d'obscurité I_{dark}. Elle est suffisamment faible pour contenir le bruit en 1/f. Dans le cas où les défauts sont des dislocations, la densité de dislocations peut être comprise entre 10⁵ dislocations/cm² et 10¹² dislocations/cm². Il est possible de mesurer la densité de dislocations par toutes techniques connues, par exemple par microscopie électronique en transmission ou par mesure XRD topographique. Il est possible de révéler les dislocations présentes dans un matériau, en le polissant et en l'immergeant dans une solution de gravure qui réagit essentiellement avec les défauts présents dans le matériau.

La région défectueuse 110 est non intentionnellement dopée, ou faiblement dopée P. Elle a une énergie de gap inférieure aux énergies de gap respectives de la couche de charge 102 et de la couche intercalaire 103. La couche de charge 102 et la couche intercalaire 103 sont en un deuxième matériau semiconducteur différent du premier matériau semiconducteur. Dans cet exemple, la cathode 105 et la couche de transition 104 sont également constituées du deuxième matériau semiconducteur, ici du silicium.

La couche petit gap 101 comporte en outre une zone dopée P constituant une anode 101.1 de la diode 5. Elle présente une concentration en porteurs majoritaires strictement supérieure à une concentration en porteurs majoritaires de la région défectueuse 110. Ici, la région défectueuse 110 et l'anode 101.1 constituent une partition de la couche petit gap 101, c'est-à-dire qu'elles sont disjointes et leur union consiste en la couche petit gap 101.

L'anode 101.1 affleure une face supérieure de la couche petit gap 101, opposée à la couche de charge 102 et à la cathode 105. Au niveau de la face supérieure, elle occupe une surface suffisante pour accueillir un contact électrique permettant de polariser la diode 5. Elle peut occuper toute la face supérieure. Elle a avantageusement une concentration en porteurs majoritaires suffisante pour permettre la réalisation d'un contact ohmique. Dans ce premier exemple, la région défectueuse 110 comporte des dislocations traversantes (« threading dislocations », en anglais), pouvant s'étendre depuis la couche de charge 102 jusqu'à la face supérieure, et se prolonger éventuellement dans l'anode 101.1.

Ici, la couche petit gap 101 est intégralement constituée du premier matériau semiconducteur. Celui-ci étant différent du deuxième matériau semiconducteur constitutif de la couche de charge 102, il est possible que des éléments atomiques provenant de l'une ou l'autre couche aient diffusés de part ou d'autre d'une interface les séparant, par exemple au cours de leur réalisation. Dans cet exemple, le premier matériau est du germanium ou un alliage de silicium-germanium. Lorsque la couche de charge 102 est en silicium, une fine couche de silicium-germanium peut être présente à l'interface résultant de la diffusion d'atomes de germanium ou de silicium provenant de l'une et/ou l'autre couche.

La couche de transition 104 a une concentration en porteurs de charges majoritaires strictement inférieure à une concentration en porteurs de charge majoritaire de la cathode 105. La cathode 105 a par exemple une concentration en atomes dopants suffisante pour réaliser un contact ohmique. Lorsqu'elle a une concentration en atomes dopants sensiblement constante dans des plans parallèles au plan principal, elle peut être obtenue par un dopage in-situ lors d'une croissance épitaxiale de la cathode 105. La présence de la couche de transition 104 peut être particulièrement avantageuse dans ce cas, notamment pour ajuster le champ électrique interne de la diode 5.

Dans des plans parallèles au plan principal, l'empilement consistant en les couches de transition 104, intercalaire 103, de charge 102 et petit gap 101 peuvent avoir des sections de bordures carrées, rectangulaires, circulaires ou elliptiques. Leurs sections sont par exemple superposées selon une vue perpendiculaire au plan principal de la diode 5. Les sections peuvent avoir une, plusieurs ou toutes ses dimensions inférieures ou égales à 40 µm, à 15 µm, voire inférieures ou égales à 10 µm.

A titre d'exemple, lorsque la cathode 105, les couches de transition 104, intercalaire 103, de charge 102 sont en silicium, et la couche petit gap 101 est en germanium, la cathode 105 peut avoir une épaisseur de 50 nm et une concentration en atomes dopants de type donneur égale à 1E19 at/cm³. La couche de transition 104 peut avoir une épaisseur de 50 nm et une concentration en atomes dopants de type donneur égale à 1E17 at/cm³. La couche intercalaire 103 peut avoir une épaisseur comprise entre 50 nm et 100 nm, et une concentration en atomes dopants inférieure ou égale à 1E15 at/cm³. La couche de charge 102 peut avoir une épaisseur comprise entre 10 nm et 100 nm, par exemple égale à 50 nm, et une concentration en atomes dopants de type accepteur comprise entre 1E17 at/cm³ et 1E18 at/cm³, par exemple égale à 2E17 at/cm³. La couche petit gap 101 peut avoir une épaisseur comprise entre 50 nm et 100nm. La région défectueuse 110 peut avoir une concentration en atomes dopants inférieure ou égal à 1E16 at/cm³.

La diode 6 de la figure 1B diffère de celle de la figure 1A en ce qu'elle comporte une interface structurée 101.5 séparant la couche de charge 102 de la couche petit gap 101, c'est-à-dire que la couche de charge 102 a une face supérieure structurée épousant une face inférieure structurée de la région défectueuse 110 et de la couche petit gap 101. La structuration de l'interface structurée 101.5 est ici de nature à confiner des dislocations de la région défectueuse 110 dans une région proche de la couche petit gap 101 proche de l'interface structurée 101.5, c'est-à-dire que la région défectueuse 110 a une hauteur mesurée perpendiculairement au plan principal strictement inférieure à la hauteur de la région défectueuse 110 du premier exemple de diode 5 de la figure 1A. La hauteur de région défectueuse 110 peut être mesurée par microscopie électronique en transmission. La couche petit gap 101 peut par conséquent comporter une région cristalline intermédiaire, sensiblement dépourvue de défauts cristallins séparent la région défectueuse 110 de l'anode 101.1. La région cristalline intermédiaire a une concentration en atomes dopant strictement inférieure à la concentration en atomes dopants de l'anode, ici sensiblement égale à la concentration en atomes dopants de la région défectueuse 110. L'anode 101.1 et la région défectueuse 110 sont deux régions disjointes de la couche petit gap 101.

L'interface structurée 101.5 comporte une répétition de motifs, par exemple périodique, et de préférence sur sensiblement toute l'interface structurée 101.5. Plusieurs types de motifs ou combinaison de motifs peuvent convenir à la structuration de l'interface structurée 101.5. Il peut s'agir de lignes parallèles, d'un quadrillage, d'un ensemble de trous ou de plots. Les motifs peuvent avoir des hauteurs mesurées perpendiculairement au plan principal comprise entre 25 nm et 50 nm. Leurs hauteurs sont de préférence supérieures ou égales à la moitié de l'épaisseur de la couche de charge 102. Tous les motifs ont préférentiellement la même hauteur. Les motifs peuvent être périodiques, par exemple des trous ou des tranchées pratiquées dans la couche de charge 102. Le cas échéant, la période peut être comprise entre 1 µm et 1,5 µm. Alternativement, l'interface structurée 101.5 peut correspondre à une rugosité de surface de la couche de charge 102.

En fonctionnement, le confinement des dislocations au voisinage de l'interface structurée 101.5 permet de concentrer les centres de génération-recombinaison de charges électriques à l'intérieur de la zone de charge d'espace, et ainsi augmenter le courant électrique SRH.

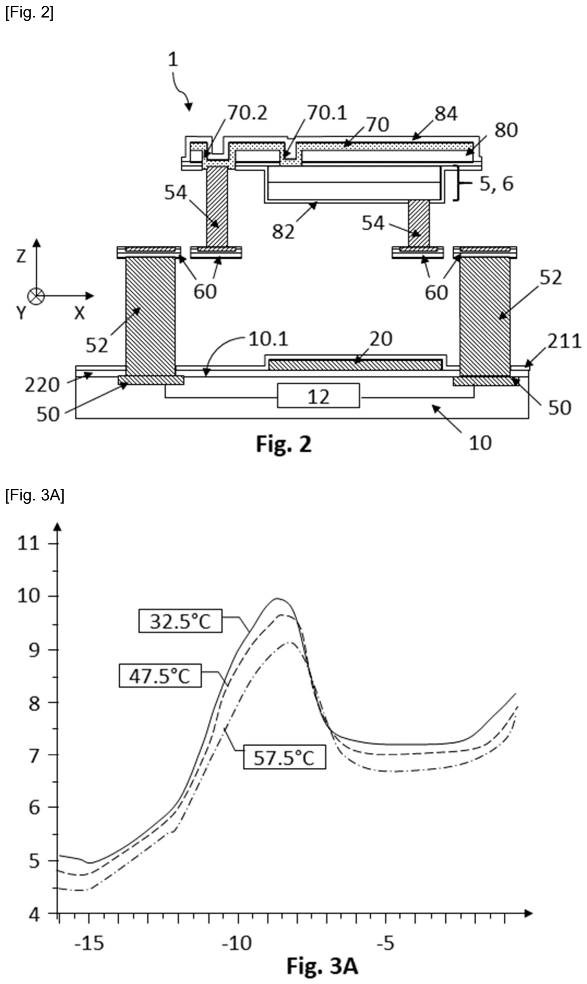

A présent, en lien avec la figure 2, un exemple de détecteur thermique 1 selon l'invention va être décrit. Celui-ci comporte une diode formée d'une hétérojonction, symbolisée par un trait plein horizontal sur la vue en coupe de la figure 2. La diode est un élément essentiel au fonctionnement d'un transducteur thermique du détecteur thermique 1. Il s'agit ici d'une diode 5, 6 selon le premier exemple ou le deuxième exemple, représentée de façon simplifiée pour ne pas surcharger la figure.

Le détecteur thermique 1 comporte un substrat de lecture 10, une micro-planche 80 suspendue au-dessus du substrat de lecture 10 par deux bras d'isolation thermique 60 du détecteur thermique 1. La micro-planche 80 est agencée en regard d'une face supérieure 10.1 du substrat de lecture 10. Le détecteur thermique 1 comporte un circuit de lecture 12. Dans cet exemple, le circuit de lecture 12 est agencé dans et/ou sur le substrat de lecture 10.

On définit ici et pour la suite de la description un repère direct tridimensionnel orthogonal (X, Y, Z) attaché au substrat de lecture 10, où les axes X et Y forment un plan parallèle à la face supérieure 10.1 du substrat de lecture 10, l'axe X étant orienté dans le plan de coupe de la figure 2, et où l'axe Z est orienté de manière sensiblement orthogonale à la face supérieure 10.1, depuis substrat de lecture 10 vers la micro-planche 80. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne du substrat de lecture 10 suivant la direction +Z. Le terme « latéral » se réfère à une orientation sensiblement parallèle à l'axe Z.

Les bras d'isolation thermique 60 sont disposés dans un plan parallèle au plan (X, Y), entre la micro-planche 80 et le substrat de lecture 10. Chaque bras d'isolation thermique 60 a une extrémité proximale fixée à la micro-planche 80 par un pilier de connexion 54, et une extrémité distale reposant sur un pilier d'ancrage 52. Chaque bras d'isolation thermique 60 est conducteur de l'électricité. Il a une section transversale et une longueur permettant d'isoler thermiquement la micro-planche 80 et la diode 5, 6, du substrat de lecture 10. Plus la surface de la section transversale est réduite et/ou plus la longueur d'un bras d'isolation thermique 60 est grande, meilleure est l'isolation thermique de la micro-planche 80. Pour augmenter la longueur, il est par exemple possible de donner à chaque bras d'isolation thermique 60 une forme en serpentin comme cela est le cas sur la figure 2. Les piliers d'ancrage 52 et les piliers de connexion 54 sont ici représentés dans le même plan de coupe, mais d'autres configurations sont possibles. Lorsque le détecteur thermique 1 est élément d'une matrice de détecteurs thermiques, un pilier d'ancrage 52 peut être partagé avec un détecteur thermique voisin.

Chaque bras d'isolation thermique 60 peut avoir un cœur métallique conducteur de l'électricité, entouré d'une gaine isolante, par exemple en un matériau résistant à une gravure servant à retirer un matériau sacrificiel sur laquelle la micro-planche 80 repose au cours d'une étape intermédiaire d'un procédé de fabrication. Dans cet exemple, le coeur est en nitrure de titane (TiN) et la gaine est en silicium amorphe, apte à résister à une gravure par de l'acide fluorhydrique en phase vapeur.

Le détecteur thermique 1 comporte un réflecteur 20 optionnel. Le réflecteur 20 est apte à réfléchir le rayonnement électromagnétique à détecter. Il est par exemple en alliage d'aluminium-cuivre (AlCu). Il s'étend sur la face supérieure 10.1, en contact avec une couche intercalaire 220 optionnelle. La couche intercalaire 220 est en contact physique avec la face supérieure 10.1 et s'étend sur sensiblement toute la surface de celle-ci, à l'exception de zones en regard de plots de connexion 50 du circuit de lecture 12. Chaque pilier de connexion 54 est connecté électriquement à un plot de connexion 50 via un bras d'isolation thermique 60 et un pilier d'ancrage 52. La couche intercalaire 220 peut par exemple être une couche de passivation ou de protection du substrat de lecture 10. Le substrat de lecture 10 avec ou sans la couche intercalaire 220 peut être fourni par une fonderie de puces semiconductrices, avant ou après découpe.

Le réflecteur 20 est recouvert par une première couche protectrice 211 optionnelle. La première couche protectrice 211 s'étend ici sur tout le réflecteur 20 et sur toute la couche intercalaire 220. Il s'agit d'une couche conforme épousant les flancs latéraux du réflecteur 20. Elle peut être en un matériau résistant à une gravure du matériau sacrificiel. La couche intercalaire 220 est ici en oxyde de silicium. La première couche protectrice 211 peut être en silicium amorphe ou en alumine.

Les piliers d'ancrage 52 traversent de part en part la première couche protectrice 211 et la couche intercalaire 220 dans une région du détecteur thermique 1 à l'intérieur de laquelle elles sont en contact, jusqu'à atteindre un plot de connexion 50 correspondant.

La diode 5, 6 est agencée sur la micro-planche 80 d'un côté de la micro-planche 80 en regard de la face supérieure 10.1 du substrat de lecture 10 et du réflecteur 20. Le plan principal de la diode 5, 6 et la micro-planche 80 s'étendent parallèlement au plan (X, Y). La diode 5, 6 est ici agencée de sorte que la cathode 105 est intercalée entre la couche petit gap 101 et la micro-planche 80. Un agencement symétrique selon une symétrie orthogonale au plan (X, Y) est également envisageable.

Le détecteur thermique 1 comprend un absorbeur 70. L'absorbeur 70 s'étend sur une face supérieure de la micro-planche 80 opposée à la diode 5, 6. Il est en contact la micro-planche 80. L'absorbeur 70 est une couche métallique conforme épousant des via traversant de part en part la micro-planche 80. Une première zone de contact électrique 70.1 de l'absorbeur 70 revêt les parois d'un via traversant la micro-planche 80 et la cathode 105 de la diode 5, 6, assurant ainsi un contact électrique avec la cathode 105. Une deuxième zone de contact électrique 70.2 de l'absorbeur 70 revêt les parois d'un autre via traversant la micro-planche 80 et un pilier de connexion 54 de sorte à réaliser un contact électrique entre l'absorbeur 70 et le pilier de connexion 54. La première zone de contact électrique 70.1 participe à coupler thermiquement l'absorbeur 70 à la diode 5, 6 par conduction thermique.

L'absorbeur 70 a avantageusement une résistance sensiblement égale à l'impédance du vide, à savoir 377 Ω/□. Il peut comprendre une ou plusieurs sous-couches métalliques de Ti, TiN, NiCr, AI, Au, W, Cu, AlCu... L'absorbeur 70 est par exemple une couche en nitrure de titane (TiN) d'épaisseur comprise entre 3 nm et 50 nm, préférentiellement comprise entre 3 nm et 10 nm. Avantageusement, lorsque l'épaisseur de l'absorbeur 70 est inférieure à son épaisseur de peau pour une longueur d'onde du rayonnement électromagnétique à détecter, l'absorbeur 70 forme avec le réflecteur 20 une cavité optique de type quart d'onde pour cette longueur d'onde, de sorte à renforcer l'absorption du rayonnement électromagnétique par l'absorbeur 70.

L'absorbeur 70 s'étend ici sur sensiblement toute la face supérieure de la micro-planche 80 afin de maximiser la quantité du rayonnement électromagnétique absorbé. L'absorbeur 70 a une impédance adaptée à celle du vide. Il transmet par conséquent partiellement dans les infrarouges lointains. Pour augmenter son absorption, et ainsi diminuer la NEP du détecteur thermique 1, il forme avec le réflecteur 20 une cavité optique de type quart d'onde pour une longueur d'onde dans la gamme LWIR. Pour plus de compacité et pour simplifier la conception du détecteur thermique 1, la diode 5, 6 est agencée à l'intérieur de la cavité optique. L'absorbeur 70 recouvre intégralement la diode 5, 6.

Des moyens du détecteur thermique 1 empêchent la diode 5, 6 d'absorber une quantité du rayonnement électromagnétique susceptible d'induire un courant électrique photo-généré supérieur au courant d'obscurité I_{dark}. La micro-planche 80 peut par exemple incorporer une portion absorbante en regard de la diode 5, 6, ou l'absorbeur 70 peut avoir une portion plus épaisse en regard de la diode 5, 6. Dans cet exemple, l'énergie de gap de la région défectueuse 110 est strictement supérieure à l'énergie du photon le plus énergétique du rayonnement électromagnétique. Ainsi, le rayonnement électromagnétique ne génère pas de porteurs de charges électriques par absorption de photons dans la zone de charge d'espace de la diode 5, 6 et aucun photo-courant n'est généré. Le silicium, le germanium et le silicium-germanium vérifient cette condition dans la gamme des infrarouges lointains. Le rayonnement électromagnétique à détecter peut être issu d'une scène à observer, éventuellement filtré par des filtres et/ou par les matériaux d'éléments optiques utilisés pour imager la scène, comme par exemple des lentilles.

Le détecteur thermique 1 comporte en outre une encapsulation inférieure 82 et une encapsulation supérieure 84. L'encapsulation inférieure 82 s'étend sur une face inférieure de la micro-planche 80, sur l'intégralité de celle-ci, et entre la micro-planche 80 et la diode 5, 6. L'encapsulation inférieure 82 recouvre en outre les flancs latéraux de la diode 5, 6 et toute une face inférieure de la diode 5, 6 opposée à la micro-planche 80. L'encapsulation supérieure 84 recouvre intégralement l'absorbeur 70 d'un côté de celui-ci opposé à la micro-planche 80, ainsi que les flancs latéraux de la micro-planche 80. Les encapsulations inférieure 82 et supérieure 84 peuvent par exemple être des couches protectrices résistantes à la gravure du matériau sacrificiel. Un pilier de connexion 54 traverse de part en part l'encapsulation inférieure 82 au regard de l'anode 101.1, de sorte à relier électriquement l'anode 101.1 au circuit de lecture 12 via le pilier de connexion 54, le bras d'isolation thermique 60 et le pilier d'ancrage 52 correspondants. La cathode 105 est connectée électriquement au circuit de lecture 12 via les première et deuxième zones de contact électrique 70.1, 70.2 et une portion de l'absorbeur 70 les reliant, ainsi que via un pilier de connexion 54, un bras d'isolation thermique 60 et un pilier d'ancrage 52 correspondants. La première zone de contact électrique 70.1 est avantageusement en contact avec une zone siliciurée de la cathode 105 comprenant du NiSi, du CoSi ou du PtSi, ceci afin de réaliser un contact ohmique de faible résistance électrique. Le pilier de connexion 54 d'anode est avantageusement en contact avec une zone siliciurée de l'anode 101.1 comprenant du NiGe, ou du TiGe, ceci afin de réaliser un contact ohmique de faible résistance électrique.

En fonctionnement, le circuit de lecture 12 polarise en inverse la diode 5, 6 à une tension de polarisation Vd égale à la différence de potentiels électriques entre l'anode 101.1 et la cathode 105. La tension de polarisation Vd est suffisante en valeur absolue pour étendre une zone de charge d'espace de la diode 5, 6 jusqu'à atteindre la région défectueuse 110. La tension de polarisation Vd est insuffisante en valeur absolue pour générer un phénomène d'ionisation par impact au sein de la diode 5, 6, c'est-à-dire que la tension de polarisation Vd est strictement inférieure à une tension de claquage en valeur absolue de la diode 5, 6. Des électrons et/ou des trous libres sont générés par agitation thermique depuis ou via des niveaux d'énergie inter-gap créés par les défauts de la région défectueuse 110, et éventuellement par des atomes dopants non activés de la couche de charge 102. La région défectueuse 110 étant dans la zone de charge d'espace, tout comme la couche de charge 102, le champ électrique interne est suffisant à leurs niveaux pour collecter les électrons et les trous générés thermiquement, respectivement à la cathode 105 et à l'anode 101.1 de la diode 5, 6. Ainsi, un courant d'obscurité I_{dark} traverse la diode 5, 6. Celui-ci est lu par le circuit de lecture 12.

Les figures 3A à 3C sont des résultats de mesure obtenus avec une diode 5 selon le premier exemple. La diode 5 a une partie supérieure cylindrique de diamètre égale à 40 µm, constituée par les couches petit gap 101, de charge 102, intercalaire 103 et de transition 104. La partie cylindrique repose sur la cathode 105. La cathode 105 est exposée sur une partie périphérique de la diode 5 sur laquelle repose un contact électrique permettant de la contacter électriquement du même côté que l'anode 101.1.

La cathode 105 et les couches de charge 102, intercalaire 103 et de transition 104 sont en silicium. La couche petit gap 101 est en germanium. La région défectueuse 110 a été générée par une épitaxie de la couche petit gap 101 sur la couche de charge 102. Les défauts de la région défectueuse 110 sont donc essentiellement des dislocations. La différence de paramètres de maille entre le germanium et le silicium est de 4, 2 %. Il a été constaté une densité de dislocations dans la région défectueuse 110 de l'ordre de 10⁷ dislocations/cm².

Les épaisseurs des couches petit gap 101, de charge 102, intercalaire 103, et de transition 104 sont respectivement égales à 1 µm, 0,08 µm, 1 µm et 0,1 µm. La cathode 105 a une épaisseur égale à 0,4 µm. Les concentrations en atomes dopants des couches petit gap 101, de charge 102, intercalaire 103, et de transition 104 sont respectivement égales 1E16 atomes/cm², 1,6E17 atomes/cm², 1E15 atomes/cm² et 1E17 atomes/cm². La concentration en atomes dopants de la cathode 105 est égale à 1E19 atomes/cm². Les couches petit gap 101, de charge 102 et intercalaire 103 sont dopées P. La couche de transition 104 et la cathode 105 sont dopées N.

La figure 3A donne la valeur mesurée du TCC en % en fonction de la tension de polarisation Vd en Volt, pour trois températures de la diode 5 repérées par un encadré (32,5 °C, 47,5 °C et 57,5 °C). Le TCC est calculé à partir de la valeur du courant d'obscurité mesuré selon la formule $TCC = \frac{1}{{I}_{dark}} \frac{{dI}_{dark}}{dT}$*.*

On constate que le TCC présente pic maximal entre -11V et -7 V. Dans cette gamme de tensions de polarisation, le TCC est supérieur à 7,5% et atteint un maximum à 10 % pour une température de la diode 5 égale à 32,5 °C. Le TCC croit entre -2 V et -1 V pour un régime de fonctionnement dominé par la diffusion de porteurs de charges électriques dans le silicium, conduisant à des valeurs de courant électrique très faibles.

Lorsque Vd diminue (augmente en valeur absolue), la largeur de la zone de charge d'espace, mesurée perpendiculairement au plan principal de la diode 5, augmente. Elle s'étend depuis la couche de transition 104 vers la couche intercalaire 103. En-deçà de -7 V, le champ électrique augmente au voisinage de la région défectueuse 110 favorisant un courant électrique SRH depuis la région défectueuse 110 qui conduit à une augmentation soudaine du courant d'obscurité I_{dark} (la valeur absolue de la pente du courant d'obscurité en fonction de la tension de polarisation augmente ainsi de 0,036 nA/V à 3,96 nA/V lorsque la tension de polarisation Vd décroît). Ce courant électrique SRH est d'autant plus important que l'énergie de gap de la région défectueuse 110 est faible et que le nombre de défauts de celle-ci est élevé. Le courant d'obscurité continue d'augmenter tant que la tension de polarisation diminue, selon une pente moins importante au-dessous de -11 V, jusqu'à atteindre la tension d'avalanche de la diode 5, en deçà de -30 V.

Dans la gamme de tensions de polarisation Vd optimale, comprise entre -11 V et -7 V, la différence d'énergie de gap entre la couche de charge 102 et la région défectueuse 110, et la distribution du champ électrique interne de la diode 5 sont telles qu'une forte variabilité du courant électrique SRH en fonction de la température est obtenue (d'autant plus élevée que les énergies de gap respectives de la couche de charge 102 et de la région défectueuse 110 sont grandes) et qu'un courant électrique SRH suffisamment élevé est lu par le circuit de lecture 12 (d'autant plus élevé que l'énergie de gap de la région défectueuse 110 est faible ou son nombre de défauts est élevé). Les concentrations en atomes dopants des couches de charge 102 et intercalaire 103, ainsi que leurs épaisseurs respectives sont telles qu'aucun phénomène d'ionisation par impacts n'intervient dans la diode 5, notamment dans la couche intercalaire 103 et dans la couche petit gap 101, lorsque le détecteur thermique 1 est en fonctionnement. Ceci permet de minimiser le bruit de lecture, notamment le bruit en 1/f. La tension d'avalanche de la diode 5 est ici inférieure à -30V.

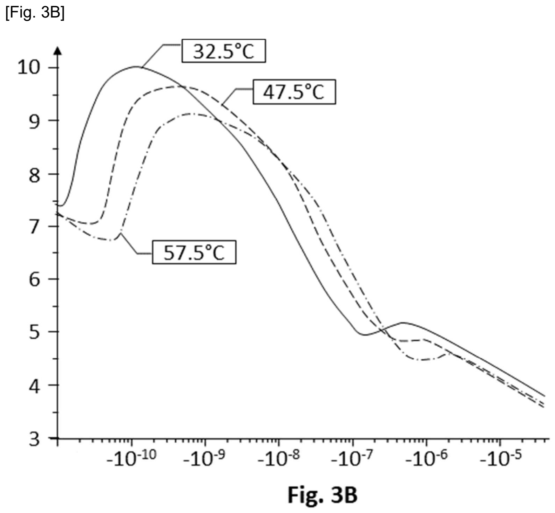

La figure 3B donne la valeur mesurée du TCC en % en fonction du courant d'obscurité I_{dark} en Ampère, pour les trois mêmes températures que celles de la figure 3A (32,5 °C, 47,5 °C et 57,5 °C). Il est constaté que les pics de TCC identifiées sur la figure 3A sont atteints pour des courants d'obscurité I_{dark} compris entre 0,1 nA et 10 nA, qui sont adaptés à un circuit de lecture 12 d'un capteur d'image thermique de type obturateur global (ou « Global Shutter », en anglais).

Un capteur d'image thermique de type obturateur global comprend généralement plusieurs détecteurs thermiques agencés en matrice. Chaque détecteur thermique correspond à un pixel de l'image. Un circuit de lecture commun à tous les pixels lit simultanément les signaux générés par tous les pixels. Lorsque chaque signal est un courant électrique, celui-ci stocke des charges électriques dans une capacité de stockage par pixel. La tension aux bornes de la capacité de stockage est caractéristique de l'intensité du rayonnement électromagnétique absorbé par le détecteur thermique correspondant. Celle-ci est lue par le circuit de lecture commun, éventuellement par comparaison avec une tension de référence. Comme il y a autant de capacités de stockage que de pixels, il convient d'en limiter leur encombrement, et par conséquent leur capacité de stockage, sans toutefois compromettre le rapport signal sur bruit du signal lu par le circuit de lecture commun. A cet effet, il est souvent admis qu'un courant électrique généré par les détecteurs thermiques compris entre 0,1 nA et 10 nA est un bon compromis.

Le détecteur thermique 1 selon l'invention peut convenir également à d'autres types de capteurs d'image thermique, comme des capteurs de type obturateur roulant (ou « rolling shutter », en anglais). Pour ce type de capteur, les signaux issus de la matrice de détecteurs thermiques sont lus ligne à ligne, ou colonne à colonne. Le courant électrique lu par le circuit de lecture commun, provenant de chaque pixel, peut dans ce cas être supérieur à 10 nA et peut atteindre quelques µA.

Sur la figure 3B, les courants d'obscurité générés aux pics de TCC augmentent avec la température de la diode 5, alors que la distribution du champ électrique interne reste sensiblement inchangée (peu de variations de la tension de polarisation Vd aux pics de TCC en fonction de la température sur la figure 3A). Il est fait l'hypothèse que l'ampleur du décalage dépend de la différence d'énergies de gap entre la couche de charge 102 et la région défectueuse 110 (évolution de la proportion relative des contributions de la couche de charge 102 et de la région défectueuse 110 au courant d'obscurité I_{dark}, en fonction de la température).

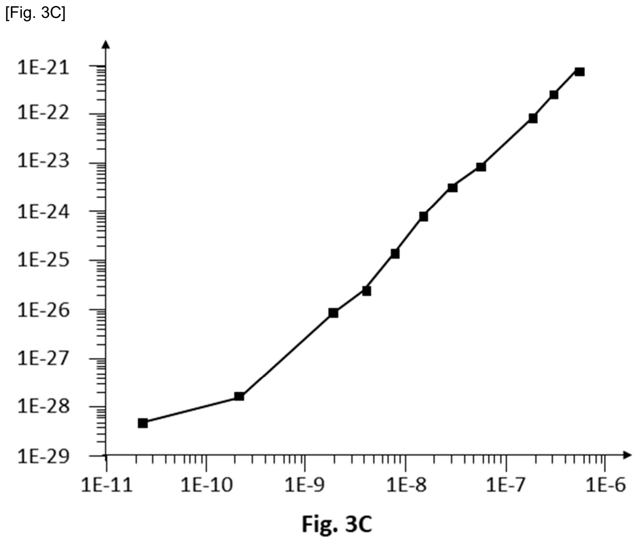

La Figure 3C donne la densité spectrale de puissance du bruit de la diode 5 de la figure 3A à 10 Hz (axe des ordonnées en A²/Hz), en fonction du courant d'obscurité I_{dark} (axe des abscisses en Ampère). La densité spectrale de puissance (ou PSD, pour « Power Spectral Density » en anglais) a été mesurée pour une température de la diode 5 égale à 30°C.

Il est constaté que la PSD reste inférieure à 3E-25 A²/Hz dans la gamme de courants d'obscurité I_{dark} comprise entre 0,1 nA et 10 nA. Ce niveau de bruit à 10 Hz est inférieur à celui de la plupart des transducteurs thermiques de l'art antérieur, notamment ceux fonctionnant avec une diode thermomètre polarisée en direct. Ce faible niveau de bruit permet d'obtenir une NEP du détecteur thermique diminuée par rapport à l'art antérieur.

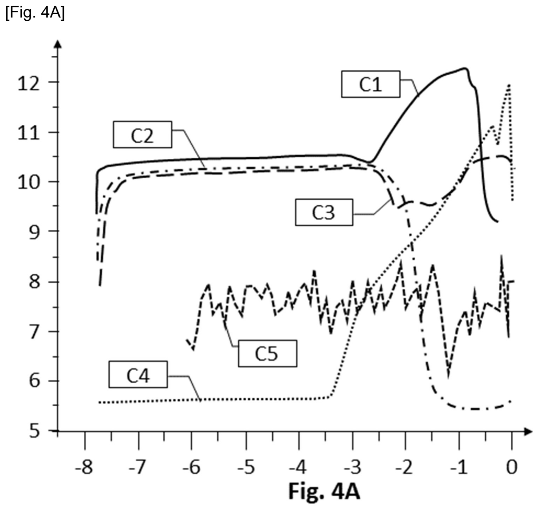

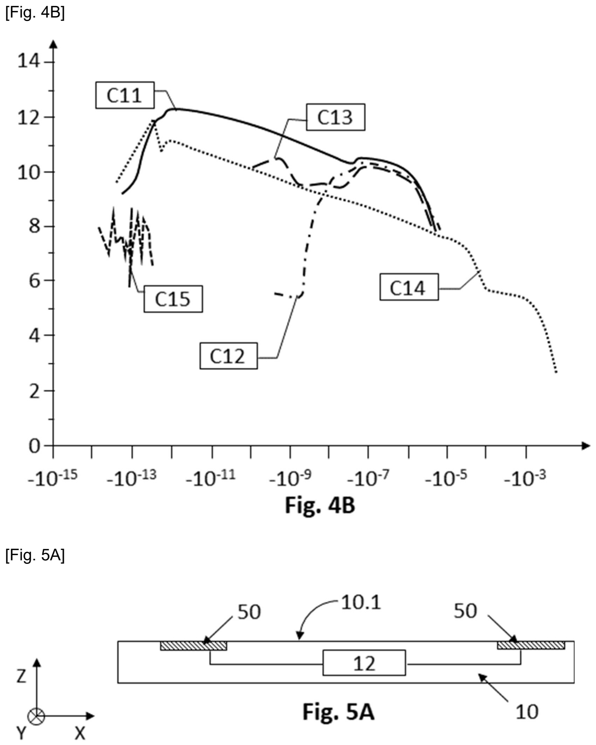

Les figures 4A et 4B donnent des résultats similaires aux figures 3A et 3B, mais cette fois obtenus par simulation, pour différents types de matériaux. La figure 4A donne la valeur du TCC en % à 32,5 °C, en fonction de la tension de polarisation Vd en Volt. La figure 4B donne ces valeurs du TCC en %, en fonction du courant d'obscurité I_{dark} en Ampère. Toutes les courbes ont été obtenues avec la même densité de dislocations dans la région défectueuse 110, égale à 10⁷ dislocations/cm².

La diode 5 est une diode selon le premier exemple, dépourvue d'interface structurée 101.5. Les épaisseurs de ses couches constitutives sont les mêmes pour toutes les courbes, et inférieures à celles des couches correspondantes de la diode 5 des figures 3A à 3C. La diode 5 est un parallélépipède rectangle de section carrée de 10 µm de côté. Elle a donc un volume bien inférieur à celle des figures 3A à 3C, et donc une capacité thermique plus faible permettant de réduire le temps de réponse du détecteur thermique 1. Les concentrations en atomes dopants des couches constitutives de la diode 5 sont identiques pour toutes les courbes.

Pour chaque courbe, les épaisseurs des couches petit gap 101, de charge 102, intercalaire 103, et de transition 104 sont respectivement égales à 0.1 µm, 0,05 µm, 0,1 µm et 0,05 µm. La cathode 105 a une épaisseur égale à 0,05 µm. Les concentrations en atomes dopants des couches petit gap 101, de charge 102, intercalaire 103, et de transition 104 sont respectivement égales 1E16 atomes/cm², 2E17 atomes/cm², 1E15 atomes/cm² et 5E17 atomes/cm². La concentration en atomes dopants de la cathode 105 est égale à 1E19 atomes/cm². Les couches petit gap 101, de charge 102 et intercalaire 103 sont dopées P. La couche de transition 104 et la cathode 105 sont dopées N.

Le Tableau 1 ci-dessous donne les matériaux des couches pour chaque courbe. Le numéro de référence de la couche est donné dans la première ligne, ainsi les matériaux de la cathode 105 sont donnés dans la dernière colonne du Tableau 1. Les références des courbes sont données dans la première colonne, ainsi la dernière ligne donne les matériaux de la courbe C5 de la figure 4A, et de la courbe C15 de la figure 4B. Les matériaux sont donnés par leurs symboles chimiques, ainsi « Ge » est du germanium.

**Tableau 1**

| | 101 | 102 | 103 | 104 | 105 |
|---|---|---|---|---|---|
| C1, C11 | Ge | Si | Si | Si | Si |
| C2, C12 | Ge | Si | Ge | Si | Si |
| C3, C13 | Ge | Ge | Si | Si | Si |
| C4, C14 | In_{0.53}Ga_{0.47}As | Si | Si | Si | Si |
| C5, C15 | GaN | Si | Si | Si | Si |

Le pic de TCC dans le cas d'une région défectueuse 110 en germanium et d'une couche de charge 102 en silicium est conservé après diminution du volume de la diode 5 (comparaison des figures 3A et 4A). Le pic de TCC intervient autour de 1,5E-3 nA. Il est supérieur à 10,6 % dans la gamme de courant d'obscurité comprise entre 0,1 nA et 10 nA (figure 4B). Le TCC est compris entre 10 % et 12 %, pour une tension de polarisation Vd comprise entre -1 V et -2,5 V et un courant d'obscurité compris entre 0,1 pA et 0,1 µA. Il est ainsi possible d'obtenir un bon TCC avec une diode 5 de capacité thermique réduite, dont les dimensions sont de plus compatibles avec des pixels de taille inférieure ou égale à 12 µm, voire inférieure ou égale à 10 µm. A noter que l'énergie de gap du germanium est égal à 0,66 eV, celui du silicium est égal à 1,12 eV, ce qui donne une différence d'énergies de gap entre la couche de charge 102 et la région défectueuse 110 égale à 0,46 eV.

On constate que, lorsque les énergies de gap de la couche de charge 102 et de la région défectueuse 110 sont égales (courbes C3 et C13), le TCC ne comporte pas de pic. Pour une région défectueuse 110 en In_{0.53}Ga_{0.47}As et une couche de charge 102 en silicium (courbes C4 et C14), le TCC est compris entre 9 % et 10,1 % dans la gamme de courant d'obscurité comprise entre 0,1 nA et 10 nA. Les énergies de gap de l'In_{0.53}Ga_{0.47}As et du silicium sont respectivement égales à 0,74 eV et 1,12 eV, soit une différence d'énergies de gap entre la couche de charge 102 et la région défectueuse 110 égale à 0,38 eV.

Lorsque l'énergie de gap de la région défectueuse 110 est supérieure à l'énergie de gap de la couche de charge 102 (courbes C5 et C15), le TCC est en deçà de 8,5 %. Il est difficilement contrôlable. De plus le courant électrique est très faible (courant d'obscurité inférieur à 1E-3 nA), insuffisant pour pouvoir être lu par le circuit de lecture 12 sans bruit électronique excessif.

Dans la gamme de courant d'obscurité comprises entre 0,1 µA et 10 µA, un bon TCC est obtenu, supérieur ou égal à 10 %, pour les courbes C11, C12 et C13. Dans la diode 5 correspondant aux courbes C2 et C12, l'énergie de gap de la couche intercalaire 103 est égale à l'énergie de gap de la région défectueuse 110.

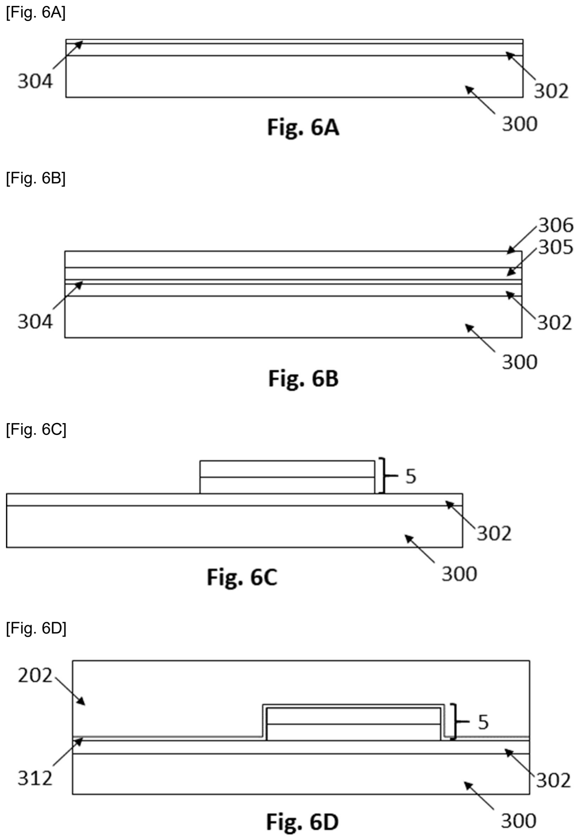

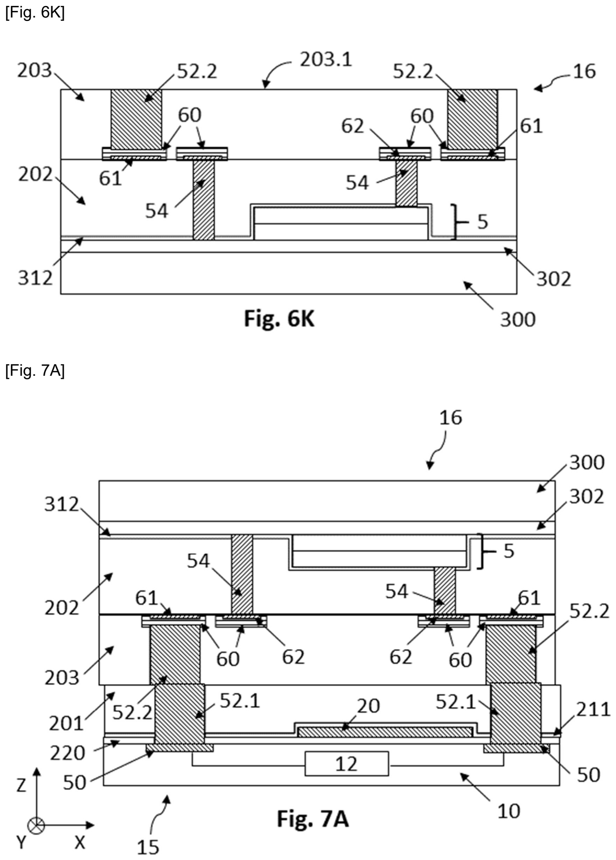

Un exemple de procédé de fabrication de détecteur thermique 1 tel qu'illustré sur la figure 2 est maintenant décrit en lien avec les figures 5A à 5D, 6A à 6K et 7A à 7J. Les figures 5A à 5D sont des vues schématiques en coupe d'étapes de fabrication d'une première partie 15 du détecteur thermique 1. Les figures 6A à 6K sont des vues schématiques en coupe d'étapes de fabrication d'une deuxième partie 16 du détecteur thermique 1. Les première et deuxième parties 15, 16 sont assemblées en figure 7A. Les figures 7A à 7J sont des vues schématiques en coupe d'étapes finales du procédé de fabrication. Sur ces vues, certains éléments peuvent avoir été omis pour ne pas surcharger les schémas. Des éléments représentés dans le plan de coupe peuvent être situés en avant-plan ou en arrière-plan sans sortir du cadre de l'invention, comme par exemple des piliers d'ancrage ou de connexion. Cet exemple de procédé de fabrication va être décrit en lien avec une combinaison particulière de conductivités associées aux couches dopées, étant entendu que le procédé de fabrication peut facilement être adapté pour couvrir toutes les combinaisons de conductivité possibles dans un détecteur thermique 1 selon l'invention.

En figure 5A, on fournit un substrat de lecture 10 comportant un circuit de lecture 12. Le circuit de lecture 12 comporte des plots de connexion 50 affleurant une face supérieure 10.1 du substrat de lecture 10. Ici, deux plots de connexion 50 sont représentés. Les plots de connexion 50 sont en un matériau conducteur de l'électricité, par exemple en métal comme un alliage d'aluminium-cuivre (AlCu).

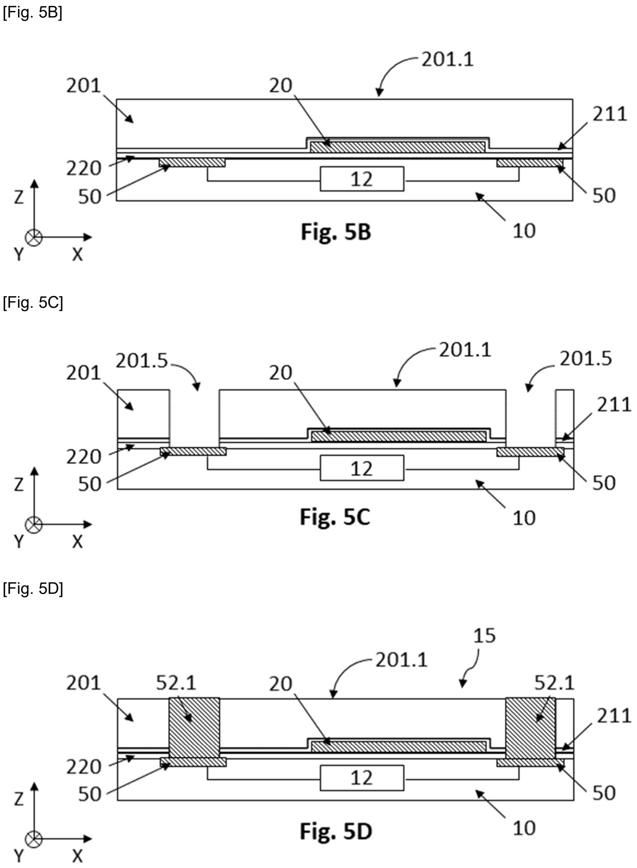

En figure 5B, on dépose sur la face supérieure 10.1 du substrat de lecture 10 et sur les plots de connexion 50, une couche intercalaire 220. La couche intercalaire 220 s'étend sur sensiblement toute la face supérieure 10.1. Elle est en un matériau diélectrique, ici en oxyde de silicium. La couche intercalaire 220 a par exemple une épaisseur de 50 nm. Il peut s'agir d'une couche de passivation et/ou de protection du substrat de lecture 10.

On forme ensuite un réflecteur 20 reposant sur la couche intercalaire 220, de manière à être en contact avec celle-ci. Pour cela, on dépose une couche métallique sur la couche intercalaire 220, ici en AlCu. La couche métallique a par exemple une épaisseur égale à 400 nm. Elle est gravée localement de part en part. Le réflecteur 20 est formé par une partie restante de la couche métallique ne recouvrant pas les plots de connexion 50.

On dépose ensuite une première couche protectrice 211 de manière conforme, sur la couche intercalaire 220 et le réflecteur 20. La première couche protectrice 211 est ici en un matériau résistant à une gravure à l'acide fluorhydrique (HF) en phase vapeur, par exemple en silicium amorphe. Dans cet exemple, l'épaisseur de la première couche protectrice 211 est inférieure à celle du réflecteur 20.

On forme ensuite une première couche sacrificielle 201 sur la première couche protectrice 211. La première couche sacrificielle 201 est en un matériau sacrificiel pouvant être gravé sélectivement par rapport à la première couche protectrice 211. Dans cet exemple, elle est en oxyde de silicium. Dans ce cas, elle peut être obtenue par un dépôt par CVD avec du TEOS en tant que gaz précurseur. La première couche sacrificielle 201 peut être aussi en polyimide.

La première couche sacrificielle 201 est polie par un polissage mécano-chimique (ou CMP, pour « Chemical Mechanical Polishing », en anglais) de sorte à obtenir une face supérieure 201.1 de la première couche sacrificielle 201 plane et parallèle au plan (X, Y). Son épaisseur mesurée parallèlement à l'axe Z à l'écart du réflecteur 20 est strictement supérieure à l'épaisseur du réflecteur 20. Elle a ici une épaisseur égale à 950 nm.

En figure 5C, on grave des ouvertures traversantes 201.5 dans la première couche sacrificielle 201 en vis-à-vis de chaque plot de connexion 50. Chaque ouverture traversante 201.5 traverse de part en part la première couche sacrificielle 201, la première couche protectrice 211 et la couche intercalaire 220. Le fond de chaque ouverture traversante 201.5 consiste en une partie d'un plot de connexion 50.

En figure 5D, on forme une base 52.1 d'un pilier d'ancrage 52 dans chaque ouverture traversante 201.5. Pour cela, on remplit intégralement les ouvertures traversantes 201.5 par du métal par un procédé damascène connu de l'art antérieur. Chaque base 52.1 affleure la face supérieure 201.1 de la première couche sacrificielle 201. Elle est ici en cuivre, éventuellement recouverte d'un revêtement métallique. A l'issue de la figure 5D, on obtient la première partie 15 du détecteur thermique 1.

En figure 6A, on fournit une plaque de type semiconducteur sur isolant. Elle comprend un substrat sacrificiel 300, une couche diélectrique 302, et une couche de croissance 304 en un matériau semiconducteur cristallin, de préférence du deuxième matériau. Il s'agit ici d'une plaque silicium sur isolant (ou SOI, pour « Silicon on Insulator » en anglais) pour laquelle le substrat sacrificiel 300 est en silicium, la couche diélectrique 302 en oxyde de silicium et la couche de croissance 304 en silicium cristallin.

Dans cet exemple de procédé, la couche de croissance 304 est destinée à accueillir la cathode 105. A cette étape, elle est dopée N, par exemple par implantation d'atomes phosphore, de préférence dans tout son volume. La concentration en atomes dopants est égale à celle attendue dans la cathode 105. Une portion dopée de la couche de croissance 304 est destinée à être la cathode 105. Dans un procédé de fabrication alternatif, la couche de croissance 304 peut être destiné à accueillir l'anode 101.1. Dans ce cas, on procède à un dopage de type P de la couche de croissance 304.

En figure 6B, on réalise une croissance épitaxiale d'une deuxième couche 305 du deuxième matériau sur la couche de croissance 304, suivi d'une croissance épitaxiale d'une première couche 306 du premier matériau sur la deuxième couche 305. Une différence de paramètres de maille et/ou une différence de coefficients de dilatation thermique entre le premier et le deuxième matériaux sont de nature à générer une sous-couche défectueuse de la première couche 306 comprenant des dislocations, préférentiellement de 10⁵ et 10¹² dislocations par cm². La sous-couche défectueuse est destinée à accueillir la région défectueuse 110.

La sous-couche défectueuse peut comporter d'autres types de défauts cristallins lors de l'épitaxie en complément ou en remplacement des dislocations, comme par exemple des joints de grains, des impuretés. Des défauts peuvent être créer après l'épitaxie par implantation ionique. Une sous-étape de traitement de surface de la deuxième couche 305 peut être prévu avant l'épitaxie de la première couche pour favoriser la formation de dislocations, comme par exemple une texturation de surface par attaque chimique ou mécanique pour créer une rugosité de surface.

La deuxième couche 305 a ici une énergie de gap strictement supérieure à une énergie de gap de la première couche 306, dite couche petit gap 306. Par opposition, la deuxième couche 305 est appelée ci-après, couche grand gap 305. La couche grand gap 305 est destinée à accueillir, dans l'ordre d'apparition au cours de la croissance, la couche de transition 104, la couche intercalaire 103 et la couche de charge 102. Un ou plusieurs dopages in-situ sont effectués dans l'équipement d'épitaxie pour obtenir les concentrations de dopage respectivement attendues dans ces couches. La couche petit gap 306 est destinée à accueillir la couche petit gap 101 avec sa région défectueuse 110 dans une partie de la sous-couche défectueuse, préférentiellement non intentionnellement dopée. L'épitaxie de la couche petit gap 306 peut se terminer par un dopage in-situ en bore pour réaliser l'anode 101.1. Une structuration de la couche grand gap 305 par une ou plusieurs étapes de photolithographie et de gravure peut être réalisée avant l'épitaxie de la couche petit gap 306 pour obtenir une diode 6 selon le deuxième exemple.

L'épaisseur de la couche grand gap 305 est égale aux épaisseurs cumulées des couches de transition 104, intercalaire 103 et de charge 102. L'épaisseur de la couche de croissance 304 est égale à l'épaisseur de la cathode 105. Et l'épaisseur de la couche petit gap 306 est égale à l'épaisseur de la couche petit gap 101.

Dans cet exemple, la couche grand gap 305 est en silicium et la couche petit gap 306 est en germanium. Dans ce cas, la couche petit gap 306 en germanium est préférentiellement protégée de l'oxydation par une couche fine cristalline en silicium (non représenté), d'épaisseur inférieure ou égale à son épaisseur critique, par exemple égale à 5 nm. La couche fine en silicium est de préférence épitaxiée à la suite de l'épitaxie de la couche petit gap 306 en germanium, sans remise à l'air, par exemple dans le même équipement d'épitaxie.

En figure 6C, on grave localement de part en part la couche petit gap 306, grand gap 305 et de croissance 304 aux dimensions de la diode 5. Sur la figure 6C et suivante, on n'a pas représenté la couche de croissance 304 puisqu'elle est ici du même matériau que la couche grand gap 305 et d'un seul tenant avec celle-ci (pas d'interface visible). Si la couche petit gap 306 n'a pas été dopée au cours de l'épitaxie dans une région de cette couche destinée à être l'anode 101.1, elle peut l'être par implantation au cours de l'étape de la figure 6C, avant ou après la gravure. L'implantation peut éventuellement être locale.

En figure 6D, on dépose de façon conforme une deuxième couche protectrice 312 sur la couche diélectrique 302 et la diode 5. On dépose ensuite une deuxième couche sacrificielle 202 sur la deuxième couche protectrice 312. La deuxième couche sacrificielle 202 est du même matériau sacrificiel que la première couche sacrificielle 201, ici en oxyde de silicium. Il peut s'agir d'un dépôt CVD à partir de TEOS suivi d'un polissage CMP. L'épaisseur de la deuxième couches sacrificielle 202 détermine la distance entre les bras d'isolation thermique 60 et la micro-planche 80. La deuxième couche sacrificielle 202 a ici une épaisseur égale à 1µm.

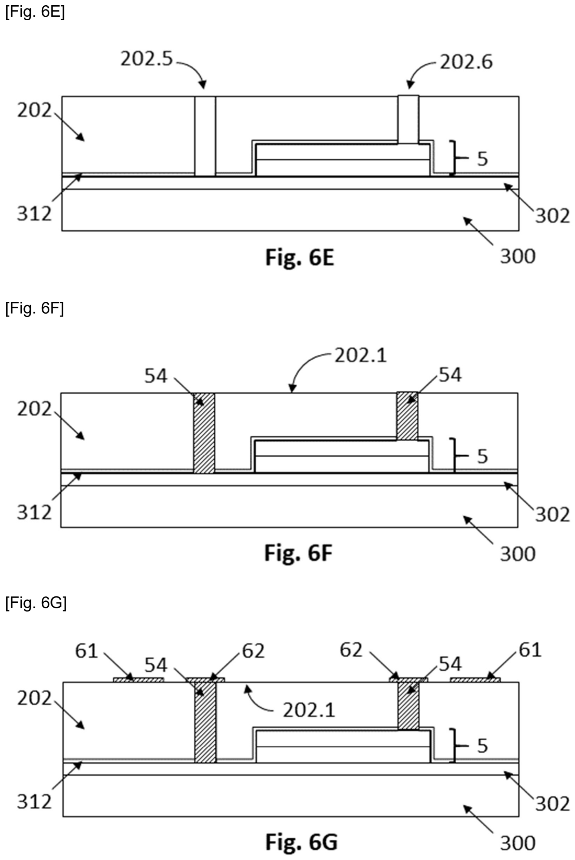

En figure 6E, on grave une ouverture traversante 202.5 traversant de part en part la deuxième couche sacrificielle 202 et la deuxième couche protectrice 312 dans une région à l'intérieur de laquelle elles sont en contact, jusqu'à atteindre la couche diélectrique 302 sans la dépasser. On grave une ouverture traversante 202.6 en regard de l'anode 101.1, traversant de part en part la deuxième couche sacrificielle 202 et la deuxième couche protectrice 312 jusqu'à atteindre l'anode 101.1, sans la dépasser.

En figure 6F, les ouvertures traversantes 202.5 et 202.6 sont entièrement remplies de métal pour former des piliers de connexion 54 dans chacune des ouvertures traversantes 202.5 et 202.6. Les piliers de connexion 54 sont par exemple en tungstène (W) revêtu d'une bicouche Ti/TiN. Ils affleurent une face libre 202.1 de la deuxième couche sacrificielle 202, opposée au substrat sacrificiel 300. La face libre 202.1 est sensiblement plane.

En figure 6G, on forme des têtes de connexion 62 sur et en contact avec chacun des piliers de connexion 54. Chaque tête de connexion 62 s'étend localement sur la face libre 202.1, parallèlement à celle-ci. Elle recouvre entièrement le pilier de connexion 54 correspondant. Les têtes de connexion 62 sont métalliques, ici en TiN.

On forme ensuite ou en même temps des plots 61 optionnels s'étendant sur la face libre 202.1 de la première couche sacrificielle 201. Les plots 61 sont en un matériau conducteur de l'électricité, par exemple en métal, ici en TiN. Les plots 61 et les têtes de connexion 62 ont ici la même hauteur mesurée perpendiculairement à la face libre 202.1.

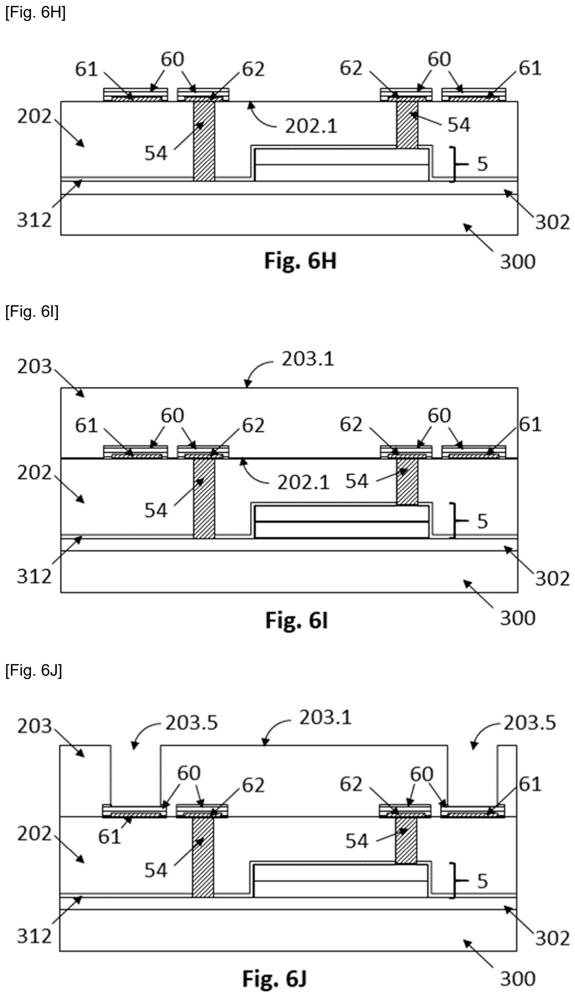

En figure 6H, on forme les bras d'isolation thermique 60. Pour cela, on dépose une première couche électriquement isolante sur la face libre 202.1, les plots 61 et les têtes de connexion 62. On pratique une ouverture traversant de part en part la première couche électriquement isolante en regard de chaque tête de connexion 62. On dépose une couche métallique de faon conforme sur la première couche électriquement isolante et dans les ouvertures, en contact avec les têtes de connexion 62. La couche métallique est séparée de chaque plot 61 par une portion de la première couche électriquement isolante. On dépose une deuxième couche électriquement isolante sur la couche métallique. On grave localement de part en part l'empilement consistant en la première couche électriquement isolante, la couche métallique et la deuxième couche électriquement isolante pour obtenir deux bras d'isolation thermique 60 à la forme désirée.

Chaque bras d'isolation thermique 60 s'étend sur la face libre 202.1 depuis une tête de connexion 62 jusqu'à un plot 61. La couche métallique est par exemple en TiN. Les première et deuxième couches électriquement isolantes sont ici en un matériau résistant à l'acide fluorhydrique. Elles peuvent être en un matériau diélectrique comme le nitrure de silicium ou en silicium amorphe.

En figure 6I, on dépose une troisième couche sacrificielle 203 sur la face libre 202.1 de la deuxième couche sacrificielle 202 et sur les bras d'isolation thermique 60. La troisième couche sacrificielle 203 est du même matériau sacrificiel que les première et deuxième couches sacrificielles 201, 202, ici en oxyde de silicium. **Il** peut s'agir d'un dépôt CVD à partir de TEOS suivi d'un polissage CMP. La troisième couche sacrificielle 203 a une face libre 203.1 plane et opposée à la deuxième couche sacrificielle 202. L'épaisseur cumulée des première, deuxième et troisième couches sacrificielles 201, 202, 203 détermine une hauteur d'une cavité quart d'onde pour une longueur d'onde du rayonnement électromagnétique, formée entre le réflecteur 20 et l'absorbeur 70.

En figure 6J, on grave une ouverture traversante 203.5 en regard de chaque plot 61, traversant de part en part la troisième couche sacrificielle 203 et une partie d'un bras d'isolation thermique 60, jusqu'à atteindre une partie conductrice de l'électricité du bras d'isolation thermique 60, ici une partie restante de la couche métallique en TiN déposée au cours de l'étape de la figure 6I.

En figure 6K, on remplit entièrement de métal chaque ouverture traversante 203.5 pour obtenir un sommet 52.2 d'un pilier d'ancrage 52 en regard de chaque plot 61. Les sommet 52.2 sont par exemple obtenus par un procédé damascène comportant un dépôt électrochimique de cuivre. Les sommets 52.2 affleurent la face libre 203.1 de la troisième couche sacrificielle 203. A l'issue de la figure 6K, on obtient la deuxième partie 16 du détecteur thermique 1.

En figure 7A, on reporte la deuxième partie 16 sur la première partie 15 par un collage hybride direct. Pour cela, on met en contact la face libre 203.1 de la troisième couche sacrificielle 203 avec la face supérieure 201.1 de la première couche sacrificielle 201, et chaque sommet 52.2 avec une base 52.1. Chaque sommet 52.2 a de préférence une section sensiblement identique à la section de la base 52.1 correspondante dans un plan défini par l'interface de collage séparant la face supérieure 201.1 de la face libre 203.1. Sur la figure 7A, la deuxième partie 16 est représentée avec un léger désalignement par rapport à la première partie 15 pouvant résulter d'une incertitude d'alignement inhérente au procédé. A l'issue de la figure 7A, chaque couple base 52.1/sommet 52.2 constitue un pilier d'ancrage 52 du détecteur thermique 1.

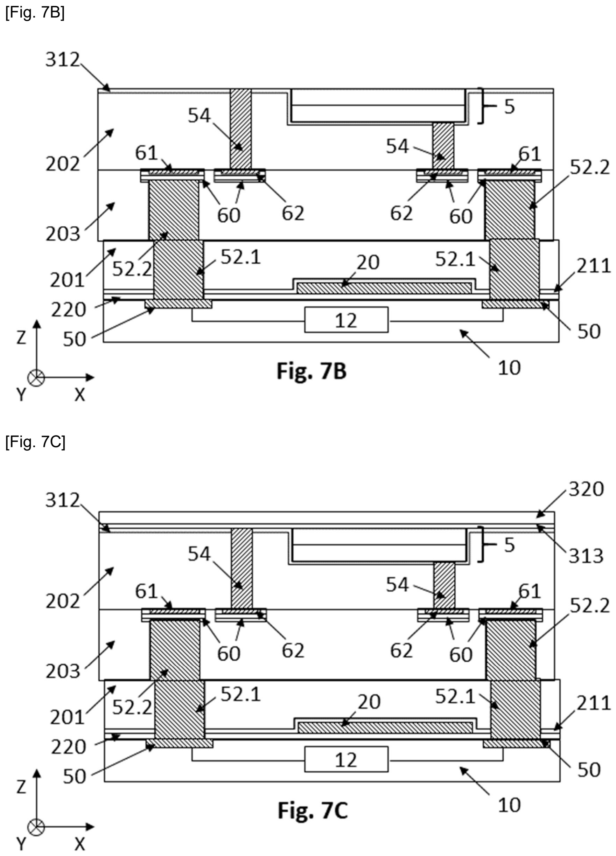

En figure 7B, on retire le substrat sacrificiel 300 et la couche diélectrique 302 pour exposer la cathode 105, la deuxième couche protectrice 312 et un pilier de connexion 54 de cathode destiné à être relié électriquement à la cathode 105. Pour cela, on peut procéder à un rodage de la majorité ou de la totalité du substrat sacrificiel 300, suivi éventuellement d'étapes de polissage et/ou de gravure chimique d'une partie restante du substrat sacrificiel 300. La couche diélectrique 302 est retiré par une gravure chimique humide sélective par rapport à la deuxième couche protectrice 312 et la cathode 105. Pour cela, elles sont avantageusement toutes deux en un même matériau, ici en silicium.

En figure 7C, on dépose une troisième couche protectrice 313 sur le pilier de connexion 54 de cathode, la cathode 105 et la deuxième couche protectrice 312, de façon à recouvrir entièrement la deuxième couche protectrice 312 et la diode 5. La troisième couche protectrice 313 est en un matériau résistant à une gravure des première, deuxième et troisième couches sacrificielles 201, 202, 203, ici en silicium amorphe ou en alumine. Les deuxième et troisième couches protectrices 312, 313 recouvrent ensemble de toutes parts la diode 5, à l'exception d'une partie de l'anode 101.1 en contact avec le pilier de connexion 54 la connectant, dit pilier de connexion 54 d'anode.

On dépose ensuite une couche diélectrique supérieure 320 sur la troisième couche protectrice 313. La couche diélectrique supérieure 320 est en tout matériau diélectrique. Elle est ici en oxyde de silicium. Une portion de la couche diélectrique supérieure 320 en regard de la diode 5 est destinée à être la micro-planche 80 du détecteur thermique 1. L'épaisseur cumulée de cette portion et des deuxième et troisième couches protectrices 312, 313 mesurée perpendiculairement à l'axe Z est suffisante pour assurer une bonne tenue mécanique de la micro-planche 80. La conduction thermique entre l'absorbeur 70 et la diode 5 augmente lorsque l'épaisseur de la troisième couche protectrice 313 et/ou de la couche diélectrique supérieure 320 diminue. Les deuxième et troisième couches protectrices 312, 313, et la couche diélectrique supérieure 320 ont ici, respectivement, des épaisseurs égales à 10 nm, à 10 nm, et à 200 nm.

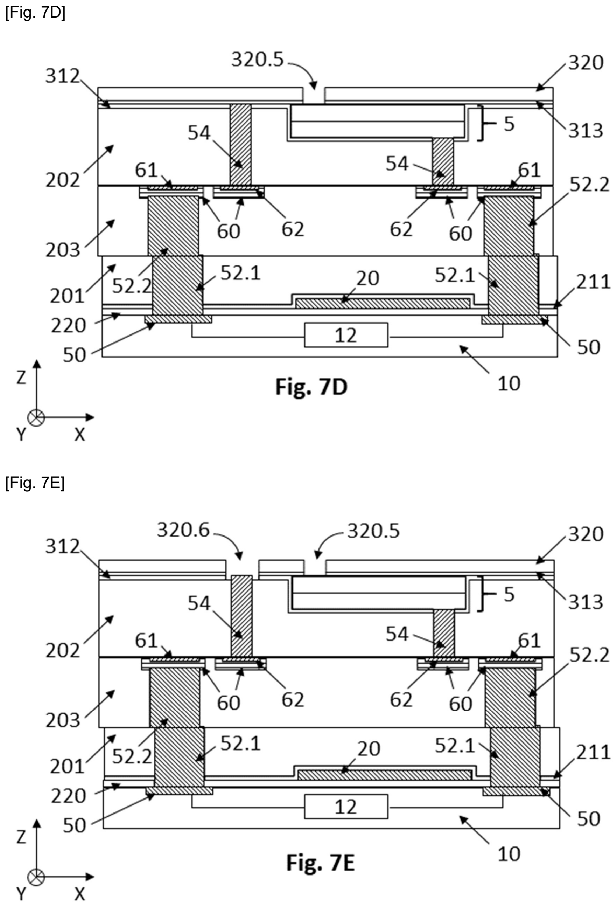

En figure 7D, on grave un premier via 320.5 traversant de part en part la couche diélectrique supérieure 320 et la troisième couche protectrice 313, en regard de la cathode 105, sans la dépasser. A l'issue de cette étape, la cathode 105 est exposée au niveau d'un fond du premier via 320.5.

En figure 7E, on grave un deuxième via 320.6 traversant de part en part la couche diélectrique supérieure 320 et la troisième couche protectrice 313 en regard du pilier de connexion 54 de cathode. A l'issue de cette étape, le pilier de connexion 54 de cathode est exposé au niveau d'un fond du deuxième via 320.6.

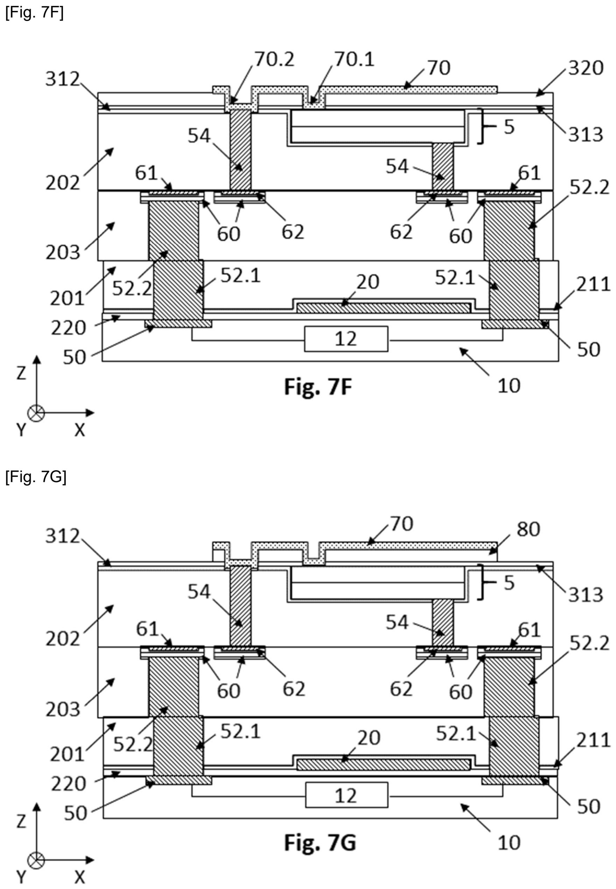

En figure 7F, on forme l'absorbeur 70. Pour cela, on dépose une couche métallique de manière conforme, sur la couche diélectrique supérieure 320 et dans les premier et deuxième via 320.5, 320.6. Cette couche métallique épouse des flancs et le fond des premier et deuxième via 320.5, 320.6. On grave ensuite localement de part en part la couche métallique pour obtenir l'absorbeur 70 aux dimensions désirées.

L'absorbeur 70 comporte une première zone de contact électrique 70.1 en contact physique avec la cathode 105 et revêtant les parois et le fond du premier via 320.5. **Il** comporte une deuxième zone de contact électrique 70.2 en contact physique avec le pilier de connexion 54 de cathode et revêtant les parois et le fond du deuxième via 320.6. Une portion de l'absorbeur 70 relie les première et deuxième zones de contact électrique 70.1, 70.2 permettant de connecter électriquement la cathode 105 au pilier de connexion 54 de cathode et au circuit de lecture 12.

En figure 7G, on grave localement de part en part la couche diélectrique supérieure 320 dans une région du détecteur thermique 1 entourant la diode 5 et les piliers de connexion 54 en vue de dessus, pour obtenir la micro-planche 80. Dans cet exemple, la micro-planche 80 et l'absorbeur 70 ont des sections coïncidentes en vue de dessus, sans que cela soit indispensable.

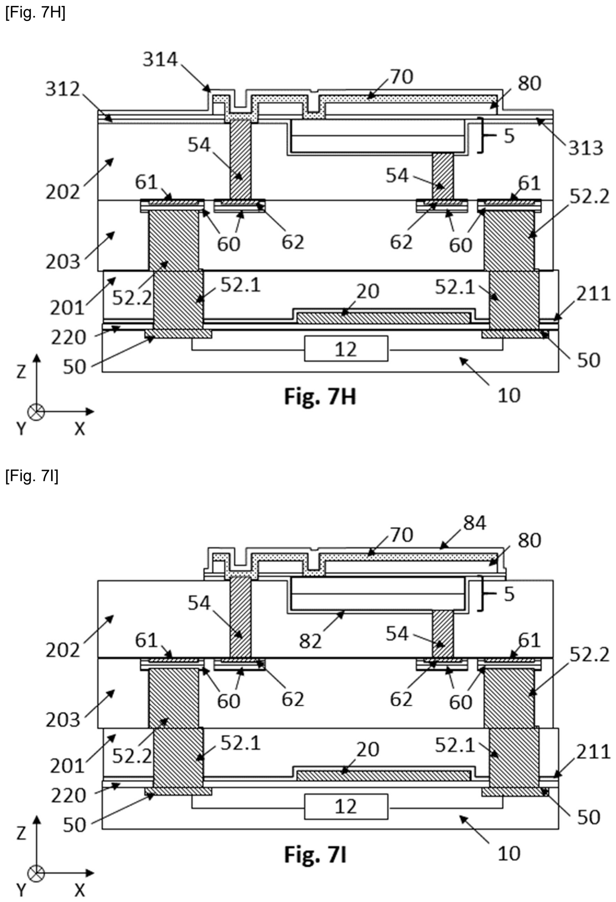

En figure 7H, on dépose une quatrième couche protectrice 314 de façon conforme sur la troisième couche protectrice 313 et sur l'absorbeur 70. La quatrième couche protectrice 314 recouvre entièrement l'absorbeur 70 et la micro-planche 80, notamment sur ses flancs latéraux. La quatrième couche protectrice 314 est en un matériau résistant à la gravure du matériau sacrificiel, ici en silicium amorphe ou en alumine.

En figure 7I, on grave localement de part en part les deuxième, troisième et quatrième couches protectrices 314 dans une région du détecteur thermique 1 entourant la diode 5, l'absorbeur 70, la micro-planche 80 en vue de dessus, à l'intérieur de laquelle la troisième couche protectrice 313 est en contact avec la deuxième couche protectrice 312 et la quatrième couche protectrice 314.

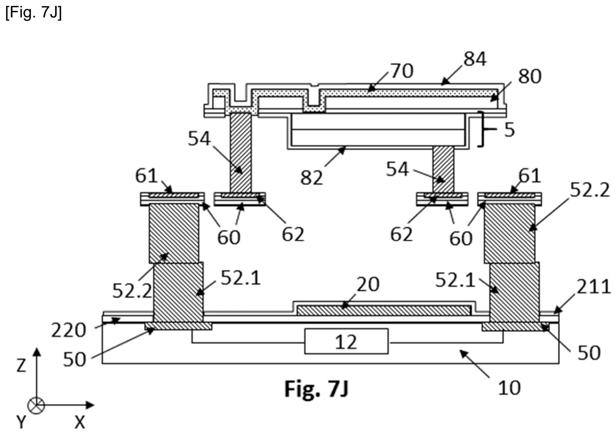

En figure 7J, on retire les première, deuxième et troisième couches sacrificielles 201, 202, 203 sélectivement par rapport aux première, deuxième, troisième et quatrième couches protectrices 211, 312, 313, 314, et par rapport aux bras d'isolation thermique 60, aux piliers d'ancrage 52 et de connexion 54. Ces trois couches sacrificielles sont retirées ici par une gravure à l'acide fluorhydrique en phase vapeur. Alternativement, il est possible d'utiliser des couches sacrificielles en polyimide, retirées par un plasma oxygène. A l'issue de la figure 7J, on obtient le détecteur thermique 1.

Des modes de réalisation particuliers viennent d'être décrits. Différentes variantes et modifications apparaîtront à l'homme du métier. Il est par exemple possible de modifier le procédé de fabrication de la deuxième partie 16 pour disposer l'absorbeur 70 entre la diode 5 et le réflecteur 20 dans le détecteur thermique 1. Les bras d'isolation thermique 60 peuvent être coplanaires avec la micro-planche 80. La micro-planche 80 peut être suspendue au-dessus d'une cavité pratiquée dans le substrat de lecture 10 lors de la fabrication de la première partie 15.

## Revendications

1. Détecteur thermique (1) d'un rayonnement électromagnétique, comportant :
o un absorbeur (70) configuré pour s'échauffer par absorption du rayonnement électromagnétique ;
o un transducteur thermique comprenant une diode (5, 6) couplée thermiquement à l'absorbeur (70), la diode (5, 6) comportant une région défectueuse (110), une couche intercalaire (103) et une couche de charge (102), toutes trois intercalées entre une anode (100.1) et une cathode (105) de la diode (5, 6), telles que :
• la couche de charge (102) a une concentration en porteurs majoritaires au moins 100 fois supérieure à une concentration en porteurs majoritaires de la couche intercalaire (103),
• la région défectueuse (110) et la couche intercalaire (103) sont en contact avec la couche de charge (102) de part et d'autre de celle-ci,
• la région défectueuse (110) comporte des défauts cristallins et a une énergie de gap strictement inférieure à une énergie de gap de la couche de charge (102),
• la couche de charge (102) et la région défectueuse (110) sont situées d'un même côté de la diode (5, 6), par rapport à une jonction de la diode (5, 6) ;
∘ le détecteur thermique (1) comporte en outre un circuit de lecture (12) configuré pour :
• polariser en inverse la diode (5, 6) à une tension de polarisation Vd strictement inférieure à sa tension de claquage en valeur absolue, de sorte à étendre une zone de charges d'espace de la diode (5, 6) jusqu'à atteindre la région défectueuse (110), et
• lire un courant d'obscurité de la diode (5, 6) lorsqu'elle est polarisée à la tension de polarisation V_{D}.

2. Détecteur thermique (1) selon la revendication 1, dans lequel la région défectueuse (110) est non intentionnellement dopée.

3. Détecteur thermique (1) selon la revendication 1 ou 2, dans lequel la diode (5, 6) comporte une couche petit gap (101) non intentionnellement dopée en contact avec la couche de charge (102), la région défectueuse (110) et l'anode (101.1) étant deux régions disjointes de la couche petit gap (101), et dans lequel la région défectueuse (110) comporte des dislocations.

4. Détecteur thermique (1) selon la revendication 3, dans lequel la diode (6) comporte une interface structurée (101.5) séparant la couche de charge (102) de la couche petit gap (101), de sorte à confiner les dislocations.

5. Détecteur thermique (1) selon la revendication 3 ou 4, dans lequel la région défectueuse (110) comporte un nombre de dislocations par cm² compris entre 10⁵ et 10¹².

6. Détecteur thermique (1) selon l'une quelconque des revendication 3 à 5, dans lequel la différence entre une énergie de gap de la couche de charge (102) et une énergie de gap de la région défectueuse (110) est supérieure à 0,38 eV.

7. Détecteur thermique (1) selon la revendication 6, dans lequel la couche intercalaire (103) et la couche de charge (102) sont en silicium, et dans lequel la couche petit gap (101) est en germanium ou en un alliage de silicium et de germanium.

8. Détecteur thermique (1) selon l'une quelconque des revendication 3 à 7, dans lequel la concentration en porteurs majoritaires de la couche de charge (102) et son agencement sont tels qu'aucune ionisation par impact intervient dans la couche petit gap (101) et dans la couche intercalaire (103) lorsque la diode (5, 6) est polarisée à la tension de polarisation Vd.

9. Détecteur thermique (1) selon l'une quelconque des revendications précédentes, dans lequel le circuit de lecture (12) est agencé dans et/ou sur un substrat de lecture (10) du détecteur thermique (1), le détecteur thermique (1) étant tel qu'il comporte une micro-planche (80) suspendue au-dessus du substrat de lecture (10), sur laquelle sont fixés la diode (5, 6) et l'absorbeur (70) de part et d'autre de celle-ci, la diode (5, 6) étant connectée électriquement au circuit de lecture (12) par une portion de l'absorbeur (70).

10. Détecteur thermique (1) selon l'une quelconque des revendications précédentes, comportant un réflecteur (20) formant avec l'absorbeur (70) une cavité optique quart d'onde pour le rayonnement électromagnétique à l'intérieur de laquelle la diode (5, 6) est agencée, la diode (5, 6) étant telle que l'énergie de gap de la région défectueuse (110) est strictement supérieure à l'énergie du photon le plus énergétique du rayonnement électromagnétique.

11. Capteur d'image thermique comportant une matrice de détecteurs thermiques (1) selon la revendication 7, le capteur d'image thermique étant à obturateur global, dans lequel le circuit de lecture (12) de chaque détecteur thermique (1) est une partie d'un circuit de lecture commun du capteur d'image, et dans lequel le circuit de lecture commun est configuré pour lire un courant d'obscurité de chaque diode (5, 6) compris entre 0,1 nA et 10 nA.

12. Procédé de fabrication d'un détecteur thermique (1) selon l'une quelconque des revendications 1 à 10, comportant une étape de formation de la région défectueuse (110) mettant en œuvre une hétéroépitaxie d'une première couche (306) sur une deuxième couche (305), respectivement en un premier matériau et en un deuxième matériau semiconducteurs, ayant des paramètres de maille différents de sorte à créer des dislocations dans une sous-couche de la première couche (306) destinée à accueillir la région défectueuse (110).

13. Procédé de fabrication selon la revendication 12, comprenant une étape d'homoépitaxie de la deuxième couche (306) sur une couche de croissance (304) comportant un dopage in-situ d'une sous-couche de la deuxième couche (306) destinée à accueillir la couche de charge (102).

14. Procédé de fabrication selon la revendication 13, dans lequel la couche de croissance (304) est destinée à accueillir la cathode (105) ou l'anode (101.1), le procédé de fabrication comprenant une étape de dopage de la couche de croissance (304) préalablement à l'étape d'homoépitaxie.

15. Procédé de fabrication selon l'une quelconque des revendications 12 à 14, comprenant une étape de structuration de la deuxième couche (305) préalablement à l'hétéroépitaxie.
